# EUROPEAN PATENT SPECIFICATION

(11) **EP 0 700 599 B1**
(45) Date of publication and mention of the grant of the patent: **01.07.1998**
(21) Application number: 95910702.0
(22) Date of filing: 17.03.1995
(51) Int. Cl.: H03K 19/094

(54) **CMOS INPUT WITH V CC? COMPENSATED DYNAMIC THRESHOLD**
CMOS EINGANG MIT VCC-KOMPENSIERTER DYNAMISCHER SCHWELLE
ENTREE DE CIRCUIT CMOS A SEUIL DYNAMIQUE COMPENSE EN V CC?

(30) Priority: 25.03.1994 US 218481
(43) Date of publication of application: 13.03.1996
(73) Proprietor: PHILIPS ELECTRONICS N.V., 5621 BA Eindhoven (NL); PHILIPS NORDEN AB, 164 85 Stockholm (SE)
(72) Inventor: MARTIN, Brian, Albuquerque, NM 87120 (US)
(74) Representative: Groenendaal, Antonius Wilhelmus Maria
(86) International application number: PCT/IB95/00183
(87) International publication number: WO 95/26590

(56) References cited:
- DE-C- 3 232 843
- JP-A- 2 070 120
- IBM Technical Disclosure Bulletin, Volume 28, No. 2, July 1985, -, "CMOS Inverter Optimization", page 790 - page 791.
- IBM Technical Disclosure Bulletin, Volume 26, No. 8, January 1984, W. HAUG et al., "Low-Voltage CMOS Logic", page 4100 - page 4101.
- PATENT ABSTRACTS OF JAPAN, Vol. 9, No. 143, E-322; & JP,A,60 025 323
- IBM Technical Disclosure Bulletin, Vol 31, No. 5, pp331-2

## Description

### FIELD OF THE INVENTION

The invention relates to an electronic circuit comprising a logic gate with a first switching threshold and having at least one input terminal for receiving at least one an input signal; an output terminal for providing an output signal; first and second supply voltage nodes for connection to respective voltage supplies; first current path means between the first supply voltage node and the output terminal for charging the output terminal in response to the input signal; second current path means between the output terminal and the second supply voltage node for discharging the output terminal in response to the input signal; additional current path means in parallel to at least a specific one of the first or second current path means; first control means responsive to the input signal for turning on the additional current path means when the respective current path is turned on; and second control means responsive to the input signal for turning off the additional current path means and comprising a buffer means with a second switching threshold different from the first switching threshold.

Such a circuit is known from IBM Technical Disclosure bulletin, Vol 31, No. 5, pp331-2. This known circuit reduces the parasitic ringing of the output during an output transition. Another such a circuit of similar structure is known from PATENTS ABSTRACTS OF JAPAN, Vol 14, No. 248 (E-933) [4191] for JP-A-2 070 120. This another known circuit controls the rise and full waveforms of the output signal.

The invention relates in particular, but not exclusively, to an electronic circuit with field-effect transistors (FETs) of complementary conductivity type, i.e., with an N-channel FET (NFET) and a P-channel FET (PFET), also commonly referred to as a CMOS circuit, and that typically performs an inverting operation such as NOT, NOR or NAND.

### BACKGROUND ART

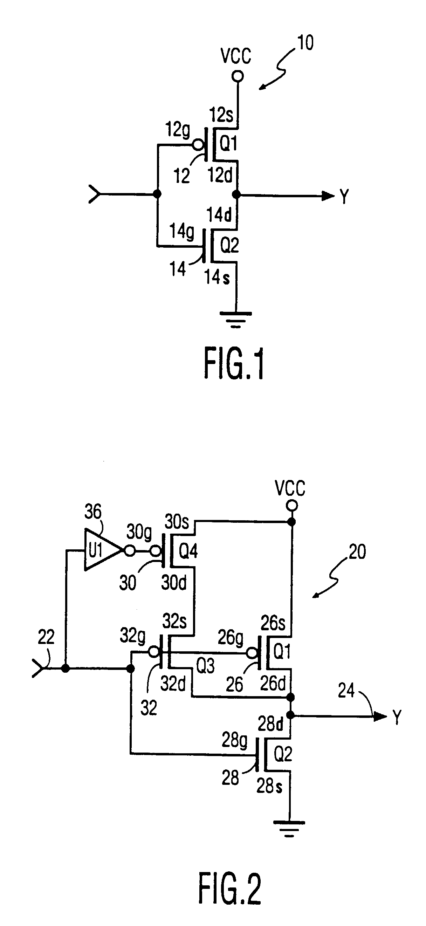

A conventional CMOS inverter 10 is shown in Fig. 1. Inverter 10 includes a PFET 12 and an NFET 14. A gate 12g of PFET 12 is coupled to a gate 14g of NFET 14. A source electrode 12s of PFET 12 is coupled to Vcc and a source electrode 14s of NFET 14 is coupled to ground. A drain electrode 12d of PFET 12 is coupled to a drain electrode 14d of NFET 14. The switching threshold of inverter 10 depends on the relative size of FETs 12 and 14 and the supply voltage Vcc. The higher the ratio of PFET to NFET, the higher the switching threshold. If it is assumed for a typical circuit that the switching threshold is Vcc/2 and that Vcc is allowed to vary from 2.7 to 3.6 volts, the switching threshold could then vary from 1.35 to 1.8 volts. This is undesirable, for example, if the input of inverter 10 is a clock pulse specified to ramp from 2.7 to 0 volts with a 2.5 ns slew rate and the design requires the propagation time of the clock signal to be independent of Vcc.

### OBJECT OF THE INVENTION

Accordingly, it is an object of the invention to provide a circuit of the type specified in the preamble, whose switching threshold is rendered substantially independent of the supply voltage level Vcc over a range of supply voltage levels.

### SUMMARY OF THE INVENTION

In accordance with the invention, this object is achieved in that the circuit is characterized in that the additional current path means comprises a first field effect transistor with a main path, and an input electrode coupled with an output of the buffer means; and a second field effect transistor with a main path, and an input electrode responsive to the input terminal; and in that the main paths of the first and the second field effect transistors are coupled in series between the first supply terminal and the output terminal.

The invention is based on the insight that the dependence of the first switching threshold of the logic gate on the supply voltage level can be compensated for through the dependence of operation of the current boosting means on the supply voltage level. By having a difference of correct polarity between the second switching threshold and the first switching threshold, the contribution of the additional current path relative to the specific current path is made to decrease with increasing supply voltage. This enables the circuit to switch at an input voltage substantially independent of the supply voltage level.

### BRIEF DESCRIPTION OF THE DRAWINGS

The invention is explained in further detail and by way of example with reference to the accompanying drawings, in which:
Fig. 1 is a circuit diagram of a prior art inverter;
Fig. 2 is a circuit diagram of a first inverter in the invention; and
Fig. 3 is a circuit diagram of a second inverter in the invention.

### DETAILED DESCRIPTION OF THE PREFERRED EMBODIMENTS

Fig. 2 depicts an inverter in accordance with a first embodiment of the present invention. Inverter 20 is operable in the range from a voltage supply Vcc to ground and has an input terminal 22 and an output terminal 24. Inverter 20 includes a first PFET 26 and an NFET 28. PFET 26 has a gate 26g coupled to input terminal 22, a source 26s coupled to Vcc, and a drain 26d. NFET 28 has a gate 28g coupled to gate 26g and to input terminal 22, a drain 28d coupled to drain 26d and a source 28s coupled to ground.

Inverter 20 also includes a second PFET 30 and a third PFET 32. Second PFET 30 includes a source 30s coupled to Vcc, a drain 30d and a gate 30g. Third PFET 32 includes a source 32s coupled to drain 30d, a drain 32d coupled to output terminal 24 and a gate 32g coupled to input terminal 22. Inverter 20 also includes a further inverter 36 having its input coupled to input terminal 22 and its output coupled to gate 30g. FETs 26 and 28 should preferably be sized so that when forming a standard inverter (consisting of FETs 26 and 28) the high-to-low switching threshold (the voltage at which standard inverter 26/28 switches) is approximately forty (40) percent of Vcc. The switching threshold of further inverter 36 should preferably be set to approximately sixty (60) percent of Vcc. This relationship allows PFETs 30 and 32 and further inverter 36 to raise the effective switching threshold as explained with the following example.

Assume the input is specified to switch between 0 to 2.7 volts and Vcc is in the range from 2.7 to 3.6 volts. If Vcc equals 2.7 volts, the switching thresholds of standard inverter 26/28, and further inverter 36 are approximately 1.1 and 1.6 volts, respectively. Prior to a high-to-low transition, further inverter 36 holds gate 30g low so that PFET 30 is turned on. PFETs 26 and 32 are off and NFET 28 is on, holding output terminal 24 to ground. At this point no current is flowing through the circuit. As the input voltage ramps down, PFETs 26 and 32 begin to turn on and NFET 28 begins to turn off. The effective switching threshold of inverter 20 is thus controlled by both by PFETs 26 and 32 and is equal to approximately 1.4 volts. When the input voltage reaches 1.6 volts, further inverter 36 begins to switch, turning PFET 30 off. However, because of a propagation delay through further inverter 36, PFET 30 does not turn off instantly. Therefore, if the input edge rate is fast enough so that the input voltage passes through 1.4 volts before PFET 30 has started to turn off, the voltage at output terminal 24 will begin to switch at 1.4 volts. As further inverter 36 turns PFET 30 off, the input voltage continues to drop past the 1.1 volts switching threshold of standard inverter 26/28, so the voltage at output terminal 24 continues to switch. As can be seen by the above example, for a fast high-to-low input transition, the effective switching threshold of inverter 20 would be approximately 1.4 volts.

If we now assume that Vcc equals 3.6 volts, the high-to-low switching thresholds of standard inverter 26/28, and further inverter 36 would be 1.4 and 2.2 volts, respectively. If the same input signal is applied to inverter 20, further inverter 36 would begin to switch sooner relative to the voltage at output terminal 24 since the difference between the switching thresholds increases as Vcc increases. Therefore, the contribution from PFET 32 to the effective switching threshold of inverter 20 would be significantly less because PFET 30 would turn off sooner. As a result, the effective switching threshold of inverter 20 would be approximately 1.5 volts. Thus, this embodiment of the invention creates a dynamic switching threshold of inverter 20 which varies by only 0.1 volts over a Vcc range of 0.9 volts.

The embodiment of Fig. 2 does not affect the switching threshold during a low-to-high transition. As the input voltage rises, the voltage passes through the switching threshold of standard inverter 26/28, before further inverter 36 turns PFET 30 on. Therefore, PFETs 30 and 32 have no function in determining the dynamic switching threshold of inverter 20.

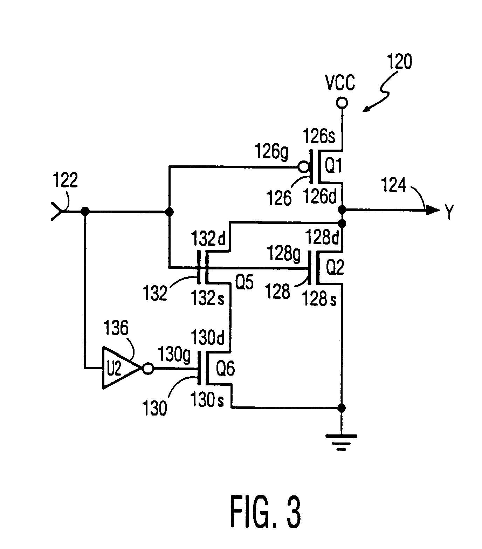

Fig. 3 illustrates an inverter 120 constructed in accordance with a second embodiment of the invention wherein the effective switching threshold is compensated for during a fast low-to-high input signal transition affected. Inverter 120 is operable in the range from a voltage supply Vcc to ground and has an input terminal 122 and an output terminal 124. Inverter 120 includes a PFET 126 and a first NFET 128. PFET 126 has a gate 126g coupled to input terminal 122, a source 126s coupled to Vcc and a drain 126d. NFET 128 has a gate 128g coupled to gate 126g, a source 126s coupled to ground and a drain 128d coupled to drain 126d.

Inverter 120 also includes a second NFET 130 and a third NFET 132. Second NFET 132 has a drain 132d coupled to output terminal 124, a source 132s and a gate 132g. Third NFET 130 has a drain 130d coupled to source 132s, a source 130s coupled to ground and a gate 130g. A further inverter 136 having its input coupled to input terminal 122 and its output coupled to gate 132g is also included in inverter 120.

FETs 126 and 128 should preferably be sized so that when forming a standard inverter (consisting of FETs 126 and 128) the low-to-high switching threshold is approximately forty (40) percent of Vcc. The low-to-high threshold of further inverter 136 should preferably be set to approximately sixty (60) percent of Vcc.

Circuit operation will be explained in accordance with the following example. Assume the input is specified to switch between 0 to 2.7 volts and Vcc is in the range of 2.7 to 3.6 volts. If Vcc equals 2.7 volts, the switching thresholds of the standard inverter 126/128 and further inverter 136 are approximately 1.6 and 1.1 volts, respectively. Prior to a low-to-high transition, further inverter 136 holds gate 130g high, turning on NFET 130. NFETs 128 and 132 are off and PFET 126 is on, holding output terminal 124 to Vcc.

As the input voltage ramps up, NFETs 128 and 132 begin to turn on and PFET 126 begins to turn off. The effective switching threshold of inverter 120 is now a combination of the effects of NFETs 128 and 132 and is approximately 1.4 volts. When the input voltage reaches 1.1 volts, further inverter 136 begins to switch, turning NFET 130 off. When NFET 130 is off, NFET 132 no longer contributes to the effective switching threshold so that the threshold returns to 1.1 volts. However, since there is a propagation delay through further inverter 136, NFET 130 does not turn off instantly. Therefore, if the input edge rate is fast enough so that the input voltage passes through 1.4 volts before NFET 130 has started to turn off, the voltage at output terminal 124 will begin to switch. As further inverter 136 turns NFET 130 off, the input voltage is continuing to rise above the 1.6, the switching threshold of standard inverter 126/128 so that the voltage at output terminal will continue to switch. As can be seen by the above example, for a fast low-to-high input transition, the effective switching threshold of inverter 120 would be approximately 1.4 volts.

If it is assumed that Vcc equals 3.6 volts, the switching thresholds of standard inverter 126/128 and further inverter 136 would be 2.2 and 1.4 volts, respectively. If the same input signal is applied to inverter 120, further inverter 136 would begin to switch sooner relative to the voltage at output terminal 124 since the difference between the switching thresholds increases as Vcc increases. Therefore, the contribution from NFET 132 to the effective low-to-high switching threshold of inverter 120 would be significantly less because NFET 130 would turn off sooner. As a result, the effective low-to-high switching threshold of inverter 120 would be approximately 1.5 volts. Thus, this embodiment of the invention creates a dynamic switching threshold for inverter 120 which varies by only 0.1 volts over a Vcc range of 0.9 volts.

The embodiment of Fig. 3 does not affect a high-to-low input signal transition. As the input voltage decreases, the voltage passes through the switching threshold of standard inverter 126/128 before further inverter 136 turns on NFET 130. Therefore, NFETs 130 and 132 do not affect the switching threshold of inverter 20.

Despite the fact that the drawing shows an inverter logic gate, it will be clear to the skilled person that the same principle is applicable to other logic gates with complementary type FETs, such as NOR gates and NAND gates.

## Claims

1. An electronic circuit comprising:
- a logic gate with a first switching threshold and having:
- at least one input terminal (22 ; 122) for receiving at least one an input signal;
- an output terminal (24 ; 124) for providing an output signal;
- first (VCC) and second supply voltage nodes for connection to respective voltage supplies;
- first current path means (Q1) between the first supply voltage node (VCC) and the output terminal for charging the output terminal in response to the input signal;
- second current path means (Q2) between the output terminal and the second supply voltage node for discharging the output terminal in response to the input signal;
- additional current path means (Q3, Q4 ; Q5, Q6) in parallel to at least a specific one of the first (Q1) or second (Q2) current path means;
- control means responsive to the input signal for turning off the additional current path means and comprising a buffer means (36 ; 136) with a second switching threshold different from the first switching threshold; characterized in that the additional current path means comprises a first field effect transistor (Q4 ; Q6) with a main path, and an input electrode coupled with an output of the buffer means (36); and a second field effect transistor (Q3 ; Q5) with a main path, and an input electrode connected to the input terminal ; and in that the main paths of the first and the second field effect transistors are coupled in series between one of said supply terminals and the output terminal.

2. The circuit of Claim 1, wherein the first current path means (Q1) comprises field effect transistors of a first conductivity type, and wherein the second current path means (Q2) comprises field effect transistors of a second conductivity type opposite to the first, and wherein the additional current path means comprises field effect transistors of a same conductivity type as the specific one of the first (Q1) and second (Q2) current path means.

## Patentansprüche

1. Elektronische Schaltungsanordnung mit einem logischen Gate mit einer ersten Schwelle und mit wenigstens einer Eingangsklemme (22, 122) zum Empfangen wenistens eines Eingangssignals; mit einer Ausgangsklemme (24, 124) zum Liefern eines Ausgangssignals; mit einem ersten (VCC) und einem zweiten Speisespannungsknotenpunkt zum Verbinden mit betreffenden Spannungslieferanten; mit einem ersten Stromstreckenmittel (Q1) zwischen dem ersten Speisespannungsknotenpunkt (VCC) und der Ausgangsklemme zum Aufladen der Ausgangsklemme in Antwort auf das Eingangssignal; mit einem zweiten Stromstreckenmittel (Q2) zwischen der Ausgangsklemme und dem zweiten Speisespannungsknotenpunkt zum Entladen der Ausgangklemme in Antwort auf das Eingangssignal; mit einem zusätzlichen Stromstreckenmittel (Q3, Q4; Q5, Q6) parallel zu wenigstens einem spezifischen Mittel der ersten (Q1) oder zweiten (Q2) Stromstreckenmittel; mit Steuermitteln, die auf das Eingangssignal reagieren, zum Abschalten des zusätzlichen Stromstreckenmittels, und mit einm Puffermittel (36; 136) mit einer zweiten Schaltschwelle, die von der ersten Schaltschwelle abweicht, dadurch gekennzeichnet, daß das zusätzliche Stromstreckenmittel einen ersten Feldeffekttransistor (Q4; Q6) mit einer Hauptstrecke aufweist, wobei eine Eingangselektrode mit einem Ausgang des Puffermittels (36) gekoppelt ist; und einen zweiten Feldeffekttransistor (Q3; Q5) mit einer Hauptstrecke, wobei eine Eingangselektrode mit der Eingangsklemme verbunden ist; und daß die Hauptstrecken des ersten und des zweiten Feldeffekttransistors zwischen einer der genannten Speiseklemmen und der Ausgangsklemme in Reihe geschaltet sind.

2. Schaltungsanordnung nach Anspruch 1, wobei das erste Stromstreckenmittel (Q1) Feldeffekttransistoren vom ersten Leitungstyp aufweist, und wobei das zweite Stromstreckenmittel (Q2) Feldeffekttransistoren vom zweiten Leitungstyp aufweist als spezifisches Exemplar des ersten (Q1) und des zweiten (Q2) Stromstreckenmittels.

## Revendications

1. Circuit électronique comprenant :
une porte logique avec un premier seuil de commutation et comportant :
- au moins une borne d'entrée (22; 122) destinée à recevoir au moins un signal d'entrée ;
- une borne de sortie (24; 124) destinée à fournir un signal de sortie ;
- un premier (VCC) et un deuxième points logiques de tension d'alimentation en vue de la connexion aux alimentations de tension respectives;
- un premier moyen à trajet de courant (Q1) entre le premier point logique de tension d'alimentation (VCC) et la borne de sortie, ayant pour fonction de charger la borne de sortie en réaction au signal d'entrée;
- un deuxième moyen à trajet de courant (Q2) entre la borne de sortie et le deuxième point logique de tension d'alimentation, ayant pour fonction de décharger la borne de sortie en réaction au signal d'entrée;
- un moyen à trajet de courant supplémentaire (Q3, Q4 ; Q5, Q6) en parallèle à au moins un moyen à trajet de courant spécifique des premier (Q1) et deuxième (Q2) moyens à trajet de courant;
- un moyen de commande réagissant au signal d'entrée afin de bloquer le moyen à trajet de courant supplémentaire et comprenant un moyen tampon (36; 136) avec un deuxième seuil de commutation différent du premier seuil de commutation;
caractérisé en ce que le moyen à trajet de courant supplémentaire comprend un premier transistor à effet de champ (Q4; Q6) avec un trajet principal et une électrode d'entrée couplée à une sortie du moyen tampon (36); ainsi qu'un deuxième transistor à effet de champ (Q3; Q5) avec un trajet principal et une électrode d'entrée connectée à la borne d'entrée; et en ce que les trajets principaux du premier et du deuxième transistors à effet de champ sont couplés en série entre l'une desdites bornes d'alimentation et la borne de sortie.

2. Circuit suivant la revendication 1, dans lequel le premier moyen à trajet de courant (Q1) comprend des transistors à effet de champ d'un premier type de conductivité, dans lequel le deuxième moyen à trajet de courant (Q2) comprend des transistors à effet de champ d'un deuxième type de conductivité opposé au premier, et dans lequel le moyen à trajet de courant supplémentaire comprend des transistors à effet de champ d'un type de conductivité identique au moyen à trajet de courant spécifique des premier (Q1) et deuxième (Q2) moyens à trajet de courant.
